Europäisches Patentamt

European Patent Office

Office européen des brevets

(19)

(11) Numéro de publication: **0 223 629**
**B1**

(12) **FASCICULE DE BREVET EUROPEEN**

(45) Date de publication du fascicule du brevet: **23.05.90**

(51) Int. Cl.5: **C 23 C 16/44, C 30 B 25/14**

(21) Numéro de dépôt: **86402040.9**

(22) Date de dépôt: **17.09.86**

(54) **Procédé et dispositif de dépôt chimique de couches minces uniformes sur de nombreux substrats plans à partir d'une phase gazeuse.**

(30) Priorité: **23.09.85 FR 8514074**

(43) Date de publication de la demande:
**27.05.87 Bulletin 87/22**

(45) Mention de la délivrance du brevet:
**23.05.90 Bulletin 90/21**

(84) Etats contractants désignés:
**AT BE CH DE GB IT LI LU NL SE**

(56) Documents cités:
**EP-A-0 131 208**
**DE-A-2 220 807**
**FR-A-2 446 327**
**GB-A- 768 733**
**US-A-3 384 049**
**US-A-4 096 822**

**PATENTS ABSTRACTS OF JAPAN, vol. 10, no. 31 (C-327)2088r, 6 février 1986; & JP-A-60 184 679 (NIPPON DENSHIN DENWA KOSHA) 20-09-1985**

(73) Titulaire: **CENTRE NATIONAL DE LA RECHERCHE SCIENTIFIQUE (CNRS)**
**15, Quai Anatole France**
**F-75007 Paris (FR)**

(72) Inventeur: **Vandenbulcke, Lionel Gérard**
**131 bis rue Demay**
**F-45650 Saint Jean Le Blanc (FR)**

(74) Mandataire: **Polus, Camille et al**
**c/o Cabinet Lavoix 2, Place d'Estienne d'Orves**
**F-75441 Paris Cedex 09 (FR)**

(56) Documents cités:

**PATENTS ABSTRACTS OF JAPAN, vol. 8, no. 222, (C-246)1659r, 9 octobre 1984; & JP-A- 59 107 071 (NITSUTOU KOUKE) 21-06-1984**

Courier Press, Leamington Spa, England.

# Description

La présente invention concerne la formation de couches minces uniformes sur de nombreux substrats plans.

Plus particulièrement, l'invention se rapporte à un procédé de formation d'une couche mince uniforme en épaisseur et en composition sur de nombreux substrats plans en une seule opération de dépôt chimique à partir d'un mélange gazeux réactif et à un dispositif pour la mise en oeuvre de ce procédé.

Les mécanismes physico-chimiques qui régissent les conditions de dépôt chimique à partir d'un mélange gazeux réactif sont de mieux en mieux connus. Les différentes étapes susceptibles de régler le processus de dépôt sont principalement le transfert de masse en phase gazeuse et la cinétique chimique homogène et surtout hétérogène. Lorsque le transfert en phase gazeuse est intrinsèquement plus rapide que la cinétique chimique, des conditions d'écart important à l'équilibre sont établies à l'interface gaz-solide, ces conditions conduisant à un dépôt de solides amorphes ou polycristallins. Ces conditions sont favorables à l'obtention de couches déposées homogènes en épaisseur et en composition sur de grandes surfaces.

Dans le cas contraire, lorsque le cinétique chimique hétérogène devient intrinsèquement plus rapide qui le transfert en phase gazeuse, des conditions se rapprochant des conditions d'équilibre hétérogène à l'interface gaz-solide sont obtenues qui conduisent à un dépôt de solides monocristallins. Ces conditions sont très défavorables à l'obtention de couches minces d'épaisseur uniforme et de composition constante sur de grandes surfaces. Les difficultés recontrées proviennent des variations de composition de la phase gazeuse en divers points de la surface d'un ou de nombreux substrats, ces variations étant dues aux conditions variables de transport en phase gazeuse, à l'appauvrissement en réactifs et à l'enrichissement en produits de réaction.

On connaît dans l'état de la technique une solution à ce problème. Cette solution consiste à compenser l'appauvrissement en réactifs par une augmentation de la vitesse des gaz avec la distance parcourue dans un réacteur, ceci étant obtenu, par exemple, par un rétrécissement progressif d'une veine gazeuse. Les dispositifs de mise en oeuvre de cette solution sont biens connus. Ce sont les réacteurs tubulaires horizontaux avec inclinaison du suscepteur et les réacteurs cylindriques verticaux avec suscepteur en forme de pyramide tronquée à n faces. Il s'agit alors de réacteurs à parois froides et les substrats plans sont placés sur les suscepteurs qui sont chauffés par induction ou par rayonnement. Les principaux inconvénients de ces dispositifs proviennent de la limitation nécessaire du rendement en réactifs transformés en solide déposé, pour que les vitesses de dépôt soient égales sur tous les substrats, d'une limitation de la surface totale revêtue due au même problème d'uniformité, mais aussi au coût énergétique élevé de tels réacteurs à parois froides. Des problèmes d'uniformité en composition ou en dopage sont également inhérents aux techniques mises en oeuvre par ces dispositifs.

Ainsi le brevet JP—A—60184678 décrit un dispositif à deux enceintes cylindriques coaxiales pour le dépôt de couches minces dans lequel le porte-substrats est chauffé directement par des moyens de chauffage au sein de l'enceinte intérieure. Le porte-substrats est monté rotatif dans l'enceinte intérieure autour de colonnes d'introduction de fluides, à axes verticaux. Ces colonnes sont amovibles afin de modifier le type de fluide introduit. Le brevet US—A—3384049 décrit un dispositif de dépôt en phase vapeur avec des moyens de chauffage d'un porte-substrats électriquement conducteur disposés dans une enceinte hermétique de Faraday, munie de moyens de refroidissement. Le porte-substrats comprend plusieurs éléments annulaires superposés munis de fentes dans lesquelles sont déposés les substrats. Ce porte-substrats est monté rotatif autour de son axe longitudinal orienté verticalement et la force centrifuge permet le maintien de substrats dans les fentes.

Ces dispositifs pour le dépôt en couches minces sont à axes verticaux et ne permettent pas des dépôts homogènes.

Le but de la présente invention est donc de résoudre les problèmes évoqués ci-dessus.

A cet effet, la présente invention a pour objet un procédé de formation de couches minces uniformes en épaisseur et composition sur de nombreux substrats plans par dépôt chimique à partir d'un mélange gazeux réactif par traitement dans un espace réactif compris entre une enceinte étanche cylindrique d'axe horizontal, mobile en rotation, dont la paroi extérieure est chauffée et dont la paroi intérieure porte les substrats, et un injecteur-éjecteur de gaz intérieur de forme générale cylindrique, fixe et refroidi, de façon que chaque substrat positionné sur la paroi intérieure, ait une position équivalente, pendant le dépôt, par rapport à l'entrée et à la sortie des gaz de l'espace réactif, la pression totale dans l'espace réactif étant au plus égale à la pression atmosphérique et la température des substrats revêtus étant maintenue constante pendant le traitement, en régulant la température de la paroi extérieure.

Selon une autre caractéristique du procédé selon l'invention, plusieurs couches minces uniformes en épaisseur et en composition sur de nombreux substrats plans sont déposées successivement en changeant la composition du mélange gazeux réactif et éventuellement la pression totale et la température des substrats.

Selon une autre caractéristique du procédé selon l'invention, les changements de composition du mélange gazeux réactif sont séparés par l'introduction dans l'espace réactif d'un gaz réducteur ou inerte seul et/ou par une opération de pompage.

Selon un autre aspect, la présente invention a également pour objet un dispositif pour la mise en oeuvre du procédé tel que défini précédemment, caractérisé en ce qu'il comprend une enceinte cylindrique étanche, d'axe horizontal, des moyens de chauffage disposés autour de cette enceinte, un porte-substrats, de paroi extérieure cylindrique, disposé dans ladite enceinte et dont la paroi intérieure, destinée à recevoir les substrats plans constitue un prisme droit régulier, ledit porte-substrats étant entraîné en rotation par des moyens d'entraînement autour d'un injecteur-éjecteur de gaz, fixe et refroidi, de forme générale cylindrique, et disposé à l'intérieur du porte-substrats, comprenant un premier cylindre permettant d'injecter le mélange gazeux dans un espace réactif délimité par le porte-substrats et l'injecteur-éjecteur de gaz, par une série d'ouvertures centrées sur la génératrice la plus basse dudit premier cylindre et un second cylindre disposé autour du premier cylindre et concentrique à celui-ci, permettant d'évacuer le mélange gazeux de l'espace réactif, par une série d'ouvertures centrées sur la génératrice la plus haute dudit second cylindre, ce second cylindre comprenant des canaux dans lesquels circule un fluide de refroidissement, les sections cylindriques de l'injecteur-éjecteur de gaz et les ouvertures des premier et second cylindres étant telles que le rapport entre la surface des sections cylindriques et la somme des surfaces des ouvertures, soit toujours au moins supérieur à deux.

L'invention sera mieux comprise à l'aide de la description qui va suivre donnée uniquement à titre d'exemple et faite en se référant aux dessins annexés sur lesquels:

la Fig. 1 est une vue schématique générale d'un dispositif selon l'invention;

la Fig. 2 représente une vue en coupe suivant la ligne A—A de la Fig. 1;

la Fig. 3 représente schématiquement un injecteur entrant dans la constitution d'un dispositif selon l'invention;

la Fig. 4a représente un développement de la surface prismatique interne d'un porte-substrats entrant dans la constitution d'un dispositif selon l'invention;

les Fig. 4b et 4c représentent respectivement des vues en coupe suivant les lignes BB et C—C du porte-substrats représenté sur la Fig. 4a;

la Fig. 4d représente une vue à échelle agrandie d'un détail des Fig. 4a, 4b et 4c; et,

la Fig. 5 représente une vue schématique en coupe d'une variante de réalisation d'un injecteur-éjecteur et d'un porte-substrats entrant dans la constitution d'un dispositif selon l'invention.

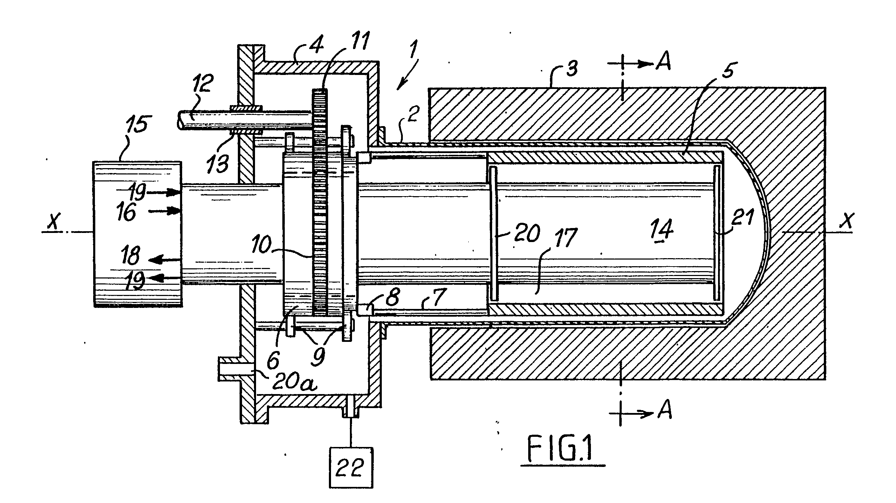

Comme on peut le voir sur la Fig. 1, un dispositif selon l'invention comporte une enceinte étanche 1 d'axe horizontal X—X comprenant une première partie cylindrique 2 autour de laquelle sont disposés des moyens de chauffage 3. Ces moyens de chauffage 3 sont montés déplaçables suivant l'axe X—X par rapport à ladite enceinte de façon à dégager la première partie cylindrique 2 de celle-ci et ainsi donner accès à cette partie cylindrique. L'enceinte 1 comporte également une seconde partie cylindrique 4 sur laquelle est fixée de manière amovible la première partie cylindrique 2 de sorte que cette première partie cylindrique peut être déplacée horizontalement pour dégager les éléments qui sont disposés à l'intérieur de celle-ci. Les moyens de chauffage 3 sont constitués par un inducteur connecté à un générateur haute fréquence, par un four chauffé par résistance ou par des moyens de chauffage par rayonnement. Ces moyens de chauffage sont commandés de manière classique pour réguler la température de la première partie de l'enceinte.

Un porte-substrats 5 présentant une paroi extérieure cylindrique est rendu solidaire d'un organe cylindrique 6 par l'intermédiaire de tiges métalliques 7 également fixées de manière amovible sur celui-ci, en 8.

Le porte-substrats 5 peut avantageusement être constitué de graphite revêtu ou non de carbure de silicium.

L'organe cylindrique 6 et donc les éléments qui en sont solidaires, c'est-à-dire le porte-substrat 5 par l'intermédiaire des tiges 7, sont montés à rotation à l'intérieur de la partie cylindrique 2 de l'enceinte par exemple par l'intermédiaire de galets 9 et d'une couronne dentée 10 solidaire de l'organe cylindrique 6 coopérant avec une roue dentée 11 solidaire d'un arbre 12 monté à rotation dans un palier étanche 13 ménagé dans une des parois de la seconde partie cylindrique 4 de l'enceinte. Cet arbre 12 est relié à des moyens mécaniques appropriés qui peuvent être constitués par tout moyen d'entraînement connu, de façon à imprimer un mouvement de rotation à l'ensemble.

Le dispositif selon l'invention comporte également un injecteur-éjecteur de gaz 14 dont une extrémité est placée à l'intérieur du porte-substrats et dont l'autre extrémité est fixée sur la seconde partie cylindrique 4 de l'enceinte. Il est à noter que cet injecteur-éjecteur de gaz traverse l'organe cylindrique 6 sur lequel est fixé le porte-substrats 5. Il est également à noter que cet injecteur-éjecteur de gaz présente une forme générale cylindrique et est coaxial au porte-substrats. Cet injecteur-éjecteur présente, à son extrémité opposée à son extrémité disposée à l'intérieur du porte-substrats 5, des moyens 15 de type connu permettant d'introduire des mélanges réactifs 16 à l'intérieur de cet injecteur-éjecteur de gaz et à l'intérieur d'un espace réactif 17 comme cela sera décrit plus en détail par la suite, cet espace réactif étant délimité en outre par le porte-substrats 5 et l'injecteur-éjecteur de gaz 14. D'autre part, ces moyens 15 permettent également de pomper des gaz 18 de cet espace réactif et de faire circuler un fluide de refroidissement 19, comme cela sera décrit par la suite, à l'intérieur de l'injecteur-éjecteur.

La partie de cet injecteur-éjecteur 14 disposée à l'intérieur du porte-substrats 5 comporte deux flasques 20 et 21 délimitant, avec le porte-substrats 5 et la partie cylindique correspondante de l'injecteur-éjecteur, l'espace de réaction 17 dans lequel s'effectuera le traitement et éventuellement un passage de gaz réducteur ou inerte additionnel introduit au-delà du flasque 21 dans la première partie cylindrique de l'enceinte, ce gaz étant alors évacué par une ouverture 20a ménagée dans la seconde partie cylindrique de celle-ci.

Selon une variante de réalisation du dispositif selon l'invention, les flasques 20 et 21 sont indépendants de d'injecteur-éjecteur de gaz 14. Ces flasques sont alors fixés sur le porte-substrats 5 qui est dans ce cas totalement fermé à son extrémité opposée à celle par laquelle l'injecteur-éjecteur de gaz pénètre dans ce porte-substrats. Il est à noter qu'une jauge de pression 22 peut également être prévue sur la seconde partie cylindrique de l'enceinte de façon à déterminer la pression régnant à l'intérieur de celle-ci.

Il est également à noter que la première partie de l'enceinte dont l'une des extrémités communique avec la seconde partie de celle-ci, est fermée à son autre extrémité.

D'autre part, le dispositif comporte des moyens que l'on recontre habituellement dans ce genre d'appareils et qui ne sont pas représentés sur cette figure. Ces moyens peuvent être constitués par exemple par un dispositif de régulation de température des moyens de chauffage 3 ou du porte-substrats 5, un système de mesure et de régulation des débits gazeux, un système de piègeage et de pompage associé à une régulation de pression commandée par la jauge 22 et divers accessoires de type connu nécessaires à l'utilisation de gaz dangereux dans les dispositifs de dépôt chimique.

Selon une variante de réalisation du dispositif selon l'invention, l'extrémité de la première partie cylindrique de l'enceinte, opposée à celle qui est fixée sur la seconde partie de celle-ci, communique avec un poste de chargement permettant de manipuler et de charger les substrats sur le porte-substrats, comme cela sera décrit par la suite.

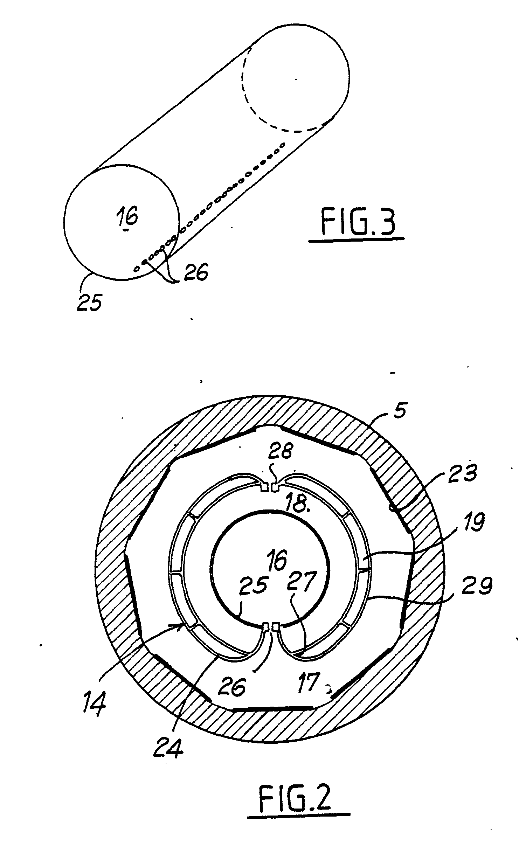

Ainsi qu'il est représenté sur la Fig. 2, le porte-substrats 5 présente une paroi extérieure cylindrique et une paroi intérieure prismatique de façon à pouvoir supporter des substrats plans 23 sur chacune de ses faces. L'injecteur-éjecteur de gaz 14 comporte un cylindre extérieur 24 et un cylindrique intérieur 25. Le cylindre intérieur 25 par lequel arrive le mélange réactif 16 présente une série d'ouvertures 26 ménagées sur la génératrice la plus basse dudit cylindre intérieur par lesquelles le mélange réactif est introduit dans l'espace réactif 17. A cet effet, le cylindre extérieur 24 présente une partie évasée 27 prolongeant ces ouvertures en direction de l'espace réactif.

Le cylindre extérieur 24 présente également une série d'ouvertures 28 ménagées sur la génératrice la plus haute de ce cylindre et permettant l'évacuation du mélange réactif 18 de l'espace réactif 17. Ce cylindre extérieur comporte également des canaux 29 dans lesquels circule un liquide de refroidissement 19.

Une réalisation d'un tel dispositif a permis de positionner neuf substrats de 76,2 mm de diamètre dans un polygone inscrit dans un cercle de 25 cm de diamètre. Des diamètres différents et notamment plus grands peuvent être utilisés sans pour cela sortir du cadre de l'invention. Il est en particulier avantageux d'opérer avec des prismes réguliers, d'un nombre de faces élevé de façon que le côté du polygone soit aussi petit que possible par rapport au diamètre du cercle dans lequel ce polygone s'inscrit. Celà permet à la fois d'augmenter le nombre de substrats, le rendement du processus de dépôt et d'approcher des conditions d'écoulement dans un cylindre. Le diamètre de l'injecteur-éjecteur est évidemment modifié en conséquence.

D'autre part, la vitesse de rotation du porte-substrats 5 est choisie en fonction des conditions de dépôt chimique à partir de la phase gazeuse. Lorsque la vitesse de déplacement des substrats est très inférieure à la vitesse d'écoulement des gaz, un seul sens de rotation du porte-substrats est employé. Cependant, il est nécessaire que la vitesse de rotation de celui-ci soit suffisante pour que l'épaisseur déposée à chaque tour soit faible par rapport à l'épaisseur totale de la couche, de façon à:

obtenir des vitesses de dépôt égales sur tous les substrats,

minimiser les différences de concentration dans l'épaisseur du dépôt, dans le cas d'un dopage ou d'un dépôt d'un alliage; les variations éventuelles de composition du solide déposé en des points situés à des distances différentes de l'entrée des réactifs, qui se retrouvent sur un substrat à chaque tour, seront donc d'autant plus facilement éliminées par diffusion dans le solide.

Tous les substrats ayant une position équivalente, par rapport à l'entrée et à la sortie des mélanges gazeux réactifs, en moyenne pendant le dépôt et les critères ci-dessus étant respectés, l'invention permet d'augmenter de façon importante le rendement en réactif transformé en solide par rapport aux techniques connues où les positions ne sont pas équivalentes et ceci sans affecter l'homogénéité des couches de substrat à substrat.

Il est également à noter que l'écoulement de la phase gazeuse s'effectue sur un même substrat dans deux directions opposées à chaque tour, correspondant aux phases ascendante et descendante du substrat, ce qui permet, avec l'appoint en général non nécessaire d'un contrôle de la vitesse de dépôt en face de l'injecteur, d'homogénéiser parfaitement l'épaisseur déposée sur chaque substrat. Un transfert élevé de masse en phase gazeuse est obtenu en face du jet lorsqu'une surface est placée à une distance du jet telle qu'elle se situe dans la zone où la vitesse des gaz se conserve lorsqu'il n'y a pas d'obstacle.

La longueur de cette zone dépend du nombre de Reynolds dans les ouvertures de l'injecteur. Cependant, elle est toujours inférieure à dix fois leur diamètre et devient très faible pour $N_{Re} \leqslant 100$.

Ainsi, sur cette Fig. 2, la distance entre les ouvertures 26 et les substrats est supérieure à 25 fois le diamètre de ces ouvertures de façon à minimiser le transfert en face du jet. Ceci est également nécessaire pour déposer des couches monocristallines en face de celui-ci.

Selon une variante de réalisation de l'invention, le jet de mélange réactif est brisé par l'interposition d'un obstacle en regard des ouvertures du cylindre 25 et cet obstacle peut être constitué par un tube non refroidi permettant par exemple d'amener un gaz du type $PH_3$, dans l'espace réactif, de façon à le chauffer préalablement à son mélange avec les autres réactifs. L'injection homogène sur toute la longueur de l'espace de réaction est basée sur les mêmes principes de fonctionnement que l'injecteur principal.

Dans une autre variante, l'injecteur central est composé de deux cylindres concentriques disposés l'un à l'intérieur de l'autre. Le cylindre intérieur permet d'injecter les gaz dans un espace annulaire situé entre les deux cylindres, par l'intermédiaire d'une série d'ouvertures ayant les mêmes caractéristiques que les ouvertures 26 évoquées précédemment, mais disposées suivant la génératrice la plus haute du cylindre intérieur. Les gaz sortent alors de l'espace annulaire par une fenêtre rectangulaire de faible largeur de un à quelques millimètres, centrée sur la génératrice la plus basse du cylindre intérieur. L'uniformité de l'injection des gaz dans l'espace de réaction est alors améliorée et la vitesse des gaz à la sortie de l'injecteur est d'autant plus diminuée que la fenêtre rectangulaire est large, évitant ainsi l'effet des "multi-jets" obtenu avec le dispositif de la Fig. 2.

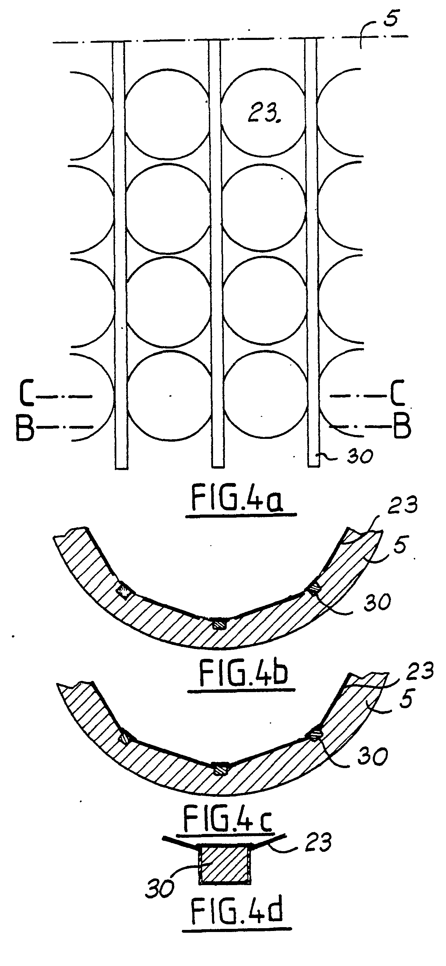

Comme il est représenté sur la Fig. 3, les ouvertures 26 sont ménagées sur la génératrice inférieure du cylindre intérieur 25. Ces ouvertures peuvent présenter, comme il a déjà été décrit, le même diamètre le long de l'injecteur. Cependant, selon un autre mode de réalisation, ce diamètre croit lorsque l'on se rapproche de l'extrémité de l'injecteur-éjecteur de gaz la plus éloignée de l'arrivée de mélange réactif 16.

Ces ouvertures peuvent également être constituées par des trous percés éventuellement dans une barrette massive soudée à l'intérieur du cylindre de façon que le rapport longueur/diamètre des ouvertures soit égal ou supérieur à 2.

Les diamètres des cylindres constituant l'injecteur-éjecteur et des ouvertures 26 sont tels que le rapport entre la surface de la section du cylindre et la somme des surfaces des sections des ouvertures soit aussi grand que possible, et toujours au moins supérieur à 2.

Si, par exemple on utilise une zone d'injection de 50 cm de longueur, des ouvertures de 0,5 mm de diamètre espacées de 0,5 mm et un cylindre de diamètre égal à 10 cm, le rapport des deux surfaces est de 80.

Pour des trous de 1 mm de diamètre espacés de 1 mm, ce rapport est de 40.

Pour des trous de 2 mm de diamètre espacés de 1 mm, ce rapport n'est plus que de 15.

Dans une variante de réalisation du dispositif selon l'invention, on peut employer un rapport plus faible à condition d'augmenter le diamètre des ouvertures, comme on l'a déjà décrit. Cependant, dans tous les cas, le flux de gaz éjecté le long du cylindre doit être uniforme. Ainsi qu'il a déjà été décrit, l'évacuation des gaz de l'espace de réaction 17 est réalisée suivant le même principe que l'injection, à travers une série d'ouvertures 28. Cette évacuation des gaz s'effectue par l'intermédiaire d'un dispositif de pompage classique.

Le fluide de refroidissement 19 est acheminé dans les canaux 29 et, après avoir effectué un ou plusieurs trajets dans ces canaux agencés autour du cylindre extérieur 24, est évacué de façon à assurer une bonne homogénéité en température sur toute la longueur de la paroi extérieure de l'injecteur-éjecteur.

Un gradient de température faible peut s'établir suivant une demi-circonférence de la paroi extérieure de celui-ci, de façon à produire une convection naturelle le long de cette paroi dans le même sens que la convection forcée dans l'espace de réaction 17.

A cet effet, divers liquides sont classiquement employés dont l'eau aux températures les plus basses. Il est également intéressant d'employer des températures de la paroi extérieure de l'injecteur-éjecteur relativement élevées pouvant aller jusqu'à une valeur d'environ 200° inférieure à la température du porte-substrats pour que la cinétique des réactions chimiques au niveau de l'injecteur soit suffisamment lente pour être négligée par rapport à la cinétique chimique dans l'espace réactif et à la surface des substrats.

La paroi extérieure de l'ensemble est alors la paroi du cylindre 24 relié au dispositif de pompage et le refroidissement est assuré dans la partie centrale de l'injecteur-éjecteur éventuellement sans contact direct avec les parois du cylindre 25 constituant l'injecteur, dans la zone chaude du dispositif.

L'ensemble du dispositif permet ainsi de choisir et de contrôler au mieux le gradient de température dans l'espace de réaction 17. D'autre part, l'injection de gaz frais s'effectuant dans la partie inférieure de celui-ci la convection naturelle assiste l'écoulement vers le haut par convection forcée.

La Figure 4a représente un développement de la surface prismatique interne du porte-substrats 5 avec les substrats circulaires 23 et un exemple non limitatif de dispositifs permettant de maintenir ces substrats sur le porte-substrats. Ces dispositifs de maintien peuvent par exemple être constitués par des réglettes 30 fixées sur le porte-substrat pour retenir les substrats en position. Les Fig. 4b et 4c représentent deux vues en coupe du porte-substrats dans lesquelles on peut s'apercevoir que les réglettes 30 sont disposées dans des rainures ménagées à cet effet entre chaque face de celui-ci.

La Fig. 4d représente une vue à échelle agrandie de la réglette 30 permettant la fixation des substrats 23 sur le porte-substrats.

Le porte-substrats 5 tel que représenté sur la Fig. 2 est monobloc. Dans ce cas, sa longueur est égale ou inférieure à environ deux fois le diamètre du cylindre dans lequel s'inscrit le polygone de façon à faciliter le chargement des substrats. Ainsi qu'il est représenté sur les Fig. 3 et 4, par exemple cinq rangées de neuf substrats de 76,2 mm de diamètre sont positionnées dans un prisme s'inscrivant dans un cylindre de 25 cm de diamètre.

Selon une variante de réalisation, le porte-substrats est composé d'une partie cylindrique extérieure sur la surface intérieure de laquelle sont fixées de manière amovible des plaques de support des substrats correspondant aux n faces du prisme intérieur. Les substrats peuvent alors être chargés sur ces plaques à l'extérieur du porte-substrat, ces plaques étant ensuite replacées à l'intérieur de la partie cylindrique de celui-ci. Le chargement des substrats sur les plaques peut par exemple s'effectuer dans un poste de chargement, comme décrit précédemment, relié à l'une des extrémités de ladite enceinte.

Dans ce cas, les moyens de chauffage 3 présentent une ouverture à chaque extrémité et l'enceinte se prolonge pour communiquer avec ce poste de chargement soit d'un porte-substrats monobloc soit des plaques amovibles qui seront ensuite replacées dans celui-ci. Ce poste est conçu de façon que l'enceinte puisse être isolée et qu'aucune remise à l'air de celle-ci n'intervienne entre deux opérations de dépôt.

Dans les modes de réalisation qui viennent d'être décrits, l'injecteur-éjecteur de gaz 14 de forme générale cylindrique est coaxial au porte-substrat.

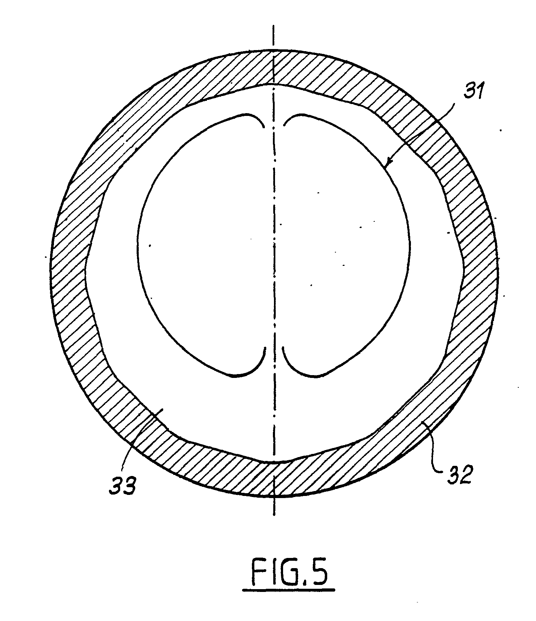

Selon une autre variante de réalisation de l'invention, un injecteur-éjecteur de gaz 31 représenté schématiquement sur la Fig. 5 est monté déplaçable verticalement dans un porte-substrats 32. L'injecteur-éjecteur 31 est alors monté déplaçable dans un plan vertical passant par le centre des ouvertures d'injection de gaz et de pompage, de sorte que l'on peut régler sa hauteur dans le porte-substrats. Dans ce cas, la vitesse d'écoulement des gaz dans un espace de réaction 33, entre l'injecteur-éjecteur 31 et le porte-substrats 32, augmente avec la distance parcourue dans cet espace de réaction, de l'entrée des gaz par les ouvertures ménagées dans la génératrice la plus basse du cylindre d'injection, jusqu'à l'évacuation de ces gaz par les ouvertures ménagées sur la génératrice la plus haute du cylindre d'éjection.

Ceci permet d'augmenter la vitesse de dépôt dans la partie haute de l'espace de réaction de façon à obtenir des vitesses de dépôt plus proches dans les différentes zones de l'espace réactif 33. L'uniformité des couches de substrat à substrat est alors obtenue pour une vitesse de rotation du porte-substrats 32 plus lente que précédemment.

En conséquence, quel que soit le mode de réalisation adopté, on dispose d'un procédé et d'un dispositif de dépôt chimique sous pression atmosphérique ou pression réduite qui présente, entre autres avantages:

celui de diminuer le coût énergétique par rapport aux réacteurs à parois froides et suscepteur chauffé par induction;

celui de permettre un meilleur contrôle et une meilleure uniformité de la température des substrats;

celui de permettre une augmentation importante du rendement de conversion des réactifs en dépôt solide, en maintenant l'homogénéité sur un substrat, et de substrats à substrats;

celui de pouvoir être extrapolé à de grandes dimensions par augmentation de la longueur et du diamètre du porte-substrat et augmentation du diamètre de l'injecteur-éjecteur, et donc de permettre le dépôt sur des grandes surfaces.

Plusieurs couches minces uniformes en épaisseur et composition peuvent ainsi être déposées en changeant la composition du mélange gazeux réactif et éventuellement la pression totale et la température des substrats. Ces changements de composition du mélange gazeux réactif sont réalisés, par exemple, après l'introduction dans l'espace réactif d'un gaz réducteur ou inerte seul et/ou après une opération de pompage comme il a été décrit.

Il est à noter que, durant chaque traitement, la pression totale dans l'espace réactif est au plus égale à la pression atmosphérique et la température des substrats revêtus est maintenue constante en régulant la température des moyens de chauffage.

L'invention trouve son application particulièrement dans les dépôts chimiques dont le processus est contrôlé principalement par le transfert en phase gazeuse, c'est-à-dire le dépôt des couches épitaxiques. Parmi les exemples les plus importants, on peut citer le dépôt du silicium, les composés II—IV et III—V qu'ils soient binaires, ternaires, etc..., par exemple Ga As ou Ga Al As.

D'autre part, l'invention trouve également son application dans le dépôt de ces derniers à partir des organométalliques et des hydrures alors que des réacteurs classiques ne permettent par d'obtenir une homogénéité suffisante sur de grandes surfaces.

Dans le cas de plaquettes de Ga As de $4 \times 2$ cm$^2$, il est possible de positionner seize plaquettes suivant une circonférence d'un cylindre de 25 cm de diamètre et quinze plaquettes bord à bord sur une longueur utile d'un cylindre de 30 cm. On peut ainsi traiter 240 plaquettes de $4 \times 2$ cm$^2$ dans un "petit" réacteur conforme à l'invention (320 dans une longueur utile de 40 cm).

A fortiori, l'invention s'applique aux dépôts chimiques dont le processus est contrôle au moins en partie par la cinétique hétérogène c'est-à-dire le dépôt des couches polycristallines. Parmi celles-ci on peut citer le silicium polycristallin à partir de silane mais également les métaux réfractaires, les siliciures, nitrures, borures, oxydes, etc....

**Revendications**

1. Procédé de formation de couches minces uniformes en épaisseur et composition sur de nombreux substrats plans (23) par dépôt chimique à partir d'un mélange gazeux réactif, comprenant le traitement lesdits substrats dans un espace réactif compris entre une enceinte étanche cylindrique (1) d'axe horizontal, mobile en rotation, dont la paroi extérieure (5) est chauffée et dont la paroi intérieure (31) de forme prismatique porte les substrats, et un injecteur-éjecteur de gaz intérieur (14, 31) de forme générale cylindrique, fixe et refroidi, de façon que chaque substrat positionné sur la paroi intérieure, ait une position équivalente, pendant le dépôt, par rapport à l'entrée et à la sortie des gaz de l'espace réactif, la pression totale des l'espace réactif étant au plus égale à la pression atmosphérique et la température des substrats revêtus étant maintenue constante pendant le traitement, en régulant la température de la paroi extérieure.

2. Procédé selon la revendication 1, caractérisé en ce qu'on dépose plusieurs couches minces uniformes en épaisseur et composition sur de nombreux substrats plans en changeant la composition du mélange gazeux réactif et éventuellement la pression totale et la température des substrats.

3. Procédé selon la revendication 2, caractérisé en ce que les changements de composition du mélange gazeux réactif sont séparés par l'introduction dans l'espace réactif d'un gaz réducteur ou inerte seul et/ou par une opération de pompage.

4. Dispositif pour la mise en oeuvre du procédé tel que défini dans les revendications précédentes, comprenant une enceinte cylindrique étanche (1), d'axe horizontal (X—X), des moyens (3) de chauffage disposés autour de cette enceinte, un porte-substrats (5; 32), de paroi extérieure cylindrique, disposé dans ladite enceinte et dont la paroi intérieure destinée à recevoir les substrats plans (23) constitue un prisme droit régulier, ledit porte-substrats étant entraîné en rotation par des moyens d'entraînement autour d'un injecteur-éjecteur (14; 31) de gaz, fixe et refroidi, de forme générale cylindrique, et disposé à l'intérieur du porte-substrats, comprenant un premier cylindre (25) permettant d'injecter le mélange gazeux dans un espace réactif (17; 33) délimité par le porte-substrats et l'injecteur-éjecteur de gaz, par une série d'ouvertures (26) centrées sur la génératrice la plus basse dudit premier cylindre et un second cylindre (24) disposé autour du premier cylindre et concentrique à celui-ci, permettant d'évacuer le mélange gazeux de l'espace réactif, par une série d'ouvertures (28) centrées sur la génératrice la plus haute dudit second cylindre, ce second cylindre (24) comprenant des canaux (29) dans lesquels circule un fluide de refroidissement (19), les sections cylindriques de l'injecteur-éjecteur de gaz et les ouvertures des premier et second cylindres étant telles que le rapport entre la surface des sections cylindriques et la somme des surfaces des ouvertures, soit toujours au moins supérieur à deux.

5. Dispositif selon la revendication 4, caractérisé en ce que ladite enceinte cylindrique (1) est constituée de silice, d'un métal ou d'un alliage métallique.

6. Dispositif selon la revendication 4 ou 5, caractérisé en ce que les moyens de chauffage (3) sont constitués par un inducteur connecté à un générateur haute fréquence.

7. Dispositif selon la revendication 4 ou 5, caractérisé en ce que lesdits moyens de chauffage (3) sont constitués par un four chauffé par résistance.

8. Dispositif selon la revendication 4 ou 5, caractérisé en ce que lesdits moyens de chauffage (3) sont constitués par des moyens de chauffage par rayonnement.

9. Dispositif selon l'une quelconque des revendications 4 à 8, caractérisé en ce que le porte-substrat (5) est constitué de graphite revêtu de carbure de silicium.

10. Dispositif selon l'une quelconque des revendications 4 à 9, caractérisé en ce que le porte-substrat (5) est monobloc.

11. Dispositif selon l'une quelconque des revendications 4 à 10, caractérisé en ce que la paroi interne du porte-substrat comporte n parties amovibles correspondant aux n faces du prisme droit régulier intérieur.

12. Dispositif selon l'une quelconque des revendications 4 à 11, caractérisé en ce que les ouvertures (26, 28) du premier (25) et du second (24) cylindres sont circulaires et d'égales dimensions tout au long de l'injecteur-éjecteur de gaz.

13. Dispositif selon l'une quelconque des revendications 4 à 11, caractérisé en ce que les ouvertures (26, 28) des premier (25) et second (24) cylindres sont circulaires et présentent un diamètre qui croît quand elles s'éloignent de l'extrémité de l'injecteur-éjecteur de gaz par laquelle le mélange gazeux arrive dans celui-ci.

14. Dispositif selon l'une quelconque des revendications 4 à 13, caractérisé en ce que l'injecteur-éjecteur de gaz (14) est coaxial audit porte-substrats (5).

15. Dispositif selon l'une quelconque des revendications 4 à 14, caractérisé en ce que l'injecteur-éjecteur de gaz (31) est monté déplaçable verticalement dans ledit porte-substrats (32) de façon à pouvoir être disposé à une hauteur quelconque à l'intérieur du porte-substrats.

16. Dispositif selon l'une quelconque des revendications 4 à 15, caractérisé en ce que l'une des extrémités de ladite enceinte (1) communique avec un poste de chargement fixé de manière étanche sur celle-ci, de manière à permettre le chargement des substrats sur le porte-substrats à partir de ce poste.

17. Dispositif selon l'une quelconque des revendications 4 à 16, caractérisé en ce que des moyens destinés à briser le jet de réactif dans l'espace réactif sont disposés en regard des ouvertures (26) ménagées dans ledit premier cylindre (25).

18. Dispositif selon la revendication 17, caractérisé en ce que lesdits moyens sont constitués par un tube permettant d'injecter un réactif particulier dans l'espace réactif.

**Patentansprüche**

1. Verfahren zur Bildung dünner Schichten gleichmäßiger Dicke und Zusammensetzung auf zahlreichen ebenen Substraten (23) durch chemische Abscheidung aus einem reaktiven Gasgemisch, das die Behandlung der Substrate in einem Reaktionsraum vorsieht, der zwischen einem dichten, zylindrischen, drehbeweglichen Gehäuse (1) mit horizontaler Achse, dessen Außenwand (5) geheizt wird und dessen Innenwand prismatischer Form die Substrate trägt, und einem festen und gekühlten inneren Gas-Injektor-Ejektor allgemein zylindrischer Form derart gebildet ist, daß jedes auf der Innenwand angeordnete Substrat während der Abscheidung eine äquivalente Lage bezüglich des Eintritts und des Austritts der Gase des Reaktionsraums hat, wobei der Gesamtdruck im Reaktionsraum höchstens gleich dem atmosphärischen Druck ist und die Temperatur der beschichteten Substrate während der Behandlung durch Regulierung der Temperatur der Außenwand konstant gehalten wird.

2. Verfahren nach dem Anspruch 1, dadurch gekennzeichnet, daß man mehrere dünne Schichten gleichmäßiger Dicke und Zusammensetzung auf zahlreichen ebenen Substraten abscheidet, indem man die Zusammensetzung des reaktiven Gasgemisches und eventuell den Gesamtdruck und die Temperatur der Substrate ändert.

3. Verfahren nach dem Anspruch 2, dadurch gekennzeichnet, daß die Zusammensetzungsänderungen des reaktiven Gasgemisches durch die Einführung eines einzelnen reduzierenden oder inerten Gases in den Reaktionsraum und/oder durch einen Pumpvorgang getrennt werden.

4. Vorrichtung zur Durchführung des in den vorstehenden Ansprüchen definierten Verfahrens, die ein dichtes, zylindrisches Gehäuse (1) mit horizontaler Achse (X—X), um dieses Gehäuse herum angeordnete Heizmittel (3) und einen Substrateträger (5; 32) mit zylindrischer Außenwand aufweist, der im Gehäuse angeordnet ist und dessen zur Aufnahme der ebenen Substrate (23) bestimmte Innenwand ein gerades regelmäßiges Prisma bildet, welcher Substrateträger durch Antriebsmittel um einen festen und gekühlten Gas-Injektor-Ejektor (14; 31) allgemein zylindrischer Form in Drehung versetzt wird, der im Inneren des Substrateträgers angeordnet ist und einen ersten Zylinder (25), der das Einführen des Gasgemisches in einen durch den Substrateträger und den Gas-Injektor-Ejektor begrenzten Reaktionsraum (17; 33) durch eine Gruppe von auf der niedrigsten Mantellinie des ersten Zylinders zentrierten Öffnungen (26) ermöglicht, sowie einem zweiten Zylinder (24) aufweist, der um den ersten Zylinder herum und konzentrisch zu diesem angeordnet ist und das Abziehen des Gasgemisches aus dem Reaktionsraum durch eine Gruppe von auf der höchsten Mantellinie des zweiten Zylinders zentrierten Öffnungen (28) ermöglicht, wobei dieser zweite Zylinder (24) Kanäle (29) aufweist, in denen ein Kühlfluid (19) zirkuliert, und die zylindrischen Abschnitte des Gas-Injektor-Ejektors und die Öffnungen des ersten und zweiten Zylinders derart sind, daß das Verhältnis zwischen der Oberfläche der zylindrischen Abschnitte und der Summe der Oberflächen der Öffnungen stets wenigstens über zwei ist.

5. Vorrichtung nach dem Anspruch 4, dadurch gekennzeichnet, daß das zylindrische Gehäuse (1) aus Siliziumdioxid, einem Metall oder einer Metallegierung besteht.

6. Vorrichtung nach dem Anspruch 4 oder 5, dadurch gekennzeichnet, daß die Heizmittel (3) aus einem mit einem Hochfrequenzgenerator verbundenen Induktor bestehen.

7. Vorrichtung nach dem Anspruch 4 oder 5, dadurch gekennzeichnet, daß die Heizmittel (3) aus einem durch Widerstand erhitzten Ofen bestehen.

8. Vorrichtung nach dem Anspruch 4 oder 5, dadurch gekennzeichnet, daß die Heizmittel (3) aus Mitteln zur Heizung durch Strahlung bestehen.

9. Vorrichtung nach irgendeinem der Ansprüche 4 bis 8, dadurch gekennzeichnet, daß der Substrateträger (5) aus mit Siliziumkarbid überzogenem Graphit besteht.

10. Vorrichtung nach irgendeinem der Ansprüche 4 bis 9, dadurch gekennzeichnet, daß der Substrateträger (5) einstückig ist.

11. Vorrichtung nach irgendeinem der Ansprüche 4 bis 10, dadurch gekennzeichnet, daß die Innenwand des Substrateträgers n lösbare, den n Flächen des inneren geraden regelmäßigen Prismas entsprechende Teile aufweist.

12. Vorrichtung nach irgendeinem der Ansprüche 4 bis 11, dadurch gekennzeichnet, daß die Öffnungen (26, 28) des ersten (25) und des zweiten (24) Zylinders kreisförmig und von gleichen Abmessungen längs des ganzen Gas-Injektor-Ejektors sind.

13. Vorrichtung nach irgendeinem der Ansprüche 4 bis 11, dadurch gekennzeichnet, daß die Öffnungen (26, 28) des ersten (25) und des zweiten (24) Zylinders kreisförmig sind und einen Durchmesser aufweisen, der wächst, wenn sie sich vom Ende des Gas-Injektor-Ejektors, durch das das Gasgemisch in diesem ankommt, entfernen.

14. Vorrichtung nach irgendeinem der Ansprüche 4 bis 13, dadurch gekennzeichnet, daß der Gas-Injektor-Ejektor (14) zum Substrateträger (5) koaxial ist.

15. Vorrichtung nach irgendeinem der Ansprüche 4 bis 14, dadurch gekennzeichnet, daß der Gas-Injektor-Ejektor (31) im Substrateträger (32) derart vertikal verschiebbar montiert ist, um in einer beliebigen Höhe im Inneren des Substrateträgers angeordnet werden zu können.

16. Vorrichtung nach irgendeinem der Ansprüche 4 bis 15, dadurch gekennzeichnet, daß das eine der Enden des Gehäuses (1) mit einer Ladestation verbunden ist, die an diesem in dichter Weise derart befestigt ist, um die Zuführung der Substrate auf den Substrateträger von dieser Station zu ermöglichen.

17. Vorrichtung nach irgendeinem der Ansprüche 4 bis 16, dadurch gekennzeichnet, daß zum Brechen des Reagensstrahls im Reaktionsraum bestimmte Mittel auf Höhe der im ersten Zylinder (25) angebrachten Öffnungen (26) angeordnet sind.

18. Vorrichtung nach dem Anspruch 17, dadurch gekennzeichnet, daß diese Mittel aus einem Rohr bestehen, das die Injektion eines besonderen Reagens' in den Reaktionsraum ermöglicht.

## Claims

1. Process for the formation of thin films of uniform thickness and composition on numerous planar substrates (23) by chemical deposition from a reactive gaseous mixture, comprising the treatment of said substrates in a reactive space between a tight, rotatable, horizontally axed, cylindrical enclosure (1), whose outer wall (5) is heated and whose prismatic inner wall (31) carries substrates and a generally cylindrical, fixed, cooled internal gas injector-ejector (14, 31), so that each substrate positioned on the inner wall has an equivalent position during deposition with respect to the entry and exit of the gases with respect to the reactive space, the total pressure in the reactive space being at the most equal to atmospheric pressure and the temperature of the coated substrates being kept constant during the treatment by regulating the temperature of the outer wall.

2. Process according to Claim 1, characterized in that several thin films of uniform thickness and composition are deposited on numerous planar substrates by changing the composition of the reactive gaseous mixture and optionally the total pressure and temperature of the substrates.

3. Process according to Claim 2, characterized in that the changes of composition of the reactive gaseous mixture are separated by the introduction into the reactive space of a reducing or inert gas only and/or by a pumping operation.

4. Apparatus for performing the process as defined in the preceding Claims, comprising a horizontally axed (X—X) tight cylindrical enclosure (1), heating means (3) arranged around said enclosure, a substrate carrier (5, 32) having a cylindrical outer wall disposed in said enclosure and whose inner wall for receiving the planar substrates (23) constitutes a regular right prism, said substrate carriers being rotated by driving means about a fixed, cooled, generally cylindrical gas injector-ejector (14, 31) and disposed within the substrate carrier, comprising a first cylinder (25) making it possible to inject the gaseous mixture into a reactive space (17, 33) defined by the substrate carrier and the gas injector-ejector, by a series of openings (26) centred on the lowest generatrix of said first cylinder and a second cylinder (24) placed around the first cylinder and concentric with respect thereto, making it possible to discharge the gaseous mixture from the reactive space, by a series of openings (28) centred on the highest generatrix of said second cylinder (24), which has channels (29) in which circulates a cooling fluid (19), the cylindrical sections of the gas injector-ejector and the openings of the first and second cylinders being such that the ratio between the surface of the cylindrical sections and the sum of the surfaces of the openings is always at least greater than two.

5. Apparatus according to Claim 4, characterized in that said cylindrical enclosure (1) is made from silica, a metal or a metal alloy.

6. Apparatus according to Claims 4 or 5, characterized in that the heating means (3) are constituted by an induction coil connected to a high frequency generator.

7. Apparatus according to Claims 4 or 5, characterized in that the heating means (3) are constituted by a resistance-heated furnace.

8. Apparatus according to Claims 4 or 5, characterized in that the heating means (3) are constituted by radiation heating means.

9. Apparatus according to any one of the Claims 4 to 8, characterized in that the substrate carrier (5) is made from silicon carbide-coated graphite.

10. Apparatus according to any one of the Claims 4 to 9, characterized in that the substrate carrier (5) is in one piece.

11. Apparatus according to any one of the Claims 4 to 10, characterized in that the inner wall of the substrate carrier has n detachable parts corresponding to the n faces of the inner regular right prism.

12. Apparatus according to any one of the Claims 4 to 11, characterized in that the openings (26, 28) of the first (25) and the second (24) cylinders are circular and of equal dimensions all along the gas injector-ejector.

13. Apparatus according to any one of the Claims 4 to 11, characterized in that the openings (26, 28) of the first (25) and second (24) cylinders are circular and have a diameter increasing when they move away from the end of the gas injector-ejector via which the gaseous mixture enters the same.

14. Apparatus according to any one of the Claims 4 to 13, characterized in that the gas injector-ejector (14) is coaxial to the substrate carrier (5).

15. Apparatus according to any one of the Claims 4 to 14, characterized in that the gas injector-ejector (31) is mounted in vertically displaceable manner in the substrate carrier (32), so that it can be located at a random height within the substrate carrier.

16. Apparatus according to any one of the Claims 4 to 15, characterized in that one of the ends of said enclosure (1) communicates with a loading station tightly fixed thereto, so as to permit the loading of the substrates on the substrate carrier from said station.

17. Apparatus according to any one of the Claims 4 to 16, characterized in that the means for interrupting the reagent jet in the reactive space are positioned facing openings (26) located in the first cylinder (25).

18. Apparatus according to Claim 17, characterized in that said means are constituted by a tube permitting the injection of a particular reagent into the reactive space.

FIG.1

FIG.3

FIG.2

5

23.

C —·—
B —·—

—·— C
—·— B

30

FIG.4a

23
5

30

FIG.4b

23
5

30

FIG.4c

23

30

FIG.4d

FIG.5